# EUROPÄISCHE PATENTSCHRIFT

(11) **EP 2 047 724 B1**
(45) Veröffentlichungstag und Bekanntmachung des Hinweises auf die Patenterteilung: **24.02.2010**
(21) Anmeldenummer: 07729101.1
(22) Anmeldetag: 14.05.2007
(51) Int. Cl.: H05K 3/28

(54) **LEITERTRÄGER UND ANORDNUNG MIT LEITERTRÄGER**
CONDUCTOR CARRIER AND ARRANGEMENT COMPRISING A CONDUCTOR CARRIER
PORTE-CONDUCTEURS ET DISPOSITIF COMPORTANT UN PORTE-CONDUCTEURS

(30) Priorität: 19.07.2006 DE 102006033477
(43) Veröffentlichungstag der Anmeldung: 15.04.2009
(73) Patentinhaber: Continental Automotive GmbH, 30165 Hannover (DE)
(72) Erfinder: FINK, Martin, 92283 Lauterhofen (DE); FISCHER, Georg, 93051 Regensburg (DE)
(86) Internationale Anmeldenummer: PCT/EP2007/054649
(87) Internationale Veröffentlichungsnummer: WO 2008/009492

(56) Entgegenhaltungen:
- EP-A- 1 217 695
- DE-A1- 19 929 179
- US-A- 3 026 234
- "INTERCONNECTION STRUCTURE FOR LIQUID CRYSTAL DISPLAY" IBM TECHNICAL DISCLOSURE BULLETIN, IBM CORP. NEW YORK, US, Bd. 31, Nr. 10, 1. März 1989 (1989-03-01), Seite 1, XP000024024 ISSN: 0018-8689

## Beschreibung

Die Erfindung betrifft einen Leiterträger, der eine Basis-Isolierfolie, eine Kontakt-Isolierfolie und zumindest eine erste und eine zweite Leiterbahn umfasst. Die erste und die zweite Leiterbahn sind zwischen den beiden Isolierfolien eingebettet.

In Kraftfahrzeugen werden regelmäßig elektronische Steuerelemente dezentralisiert angeordnet. Beispielsweise wird in einem Automatikgetriebe für Kraftfahrzeuge die entsprechende Steuerelektronik und die dazu gehörige Sensorik in das Getriebegehäuse des Automatikgetriebes eingebaut. Ähnliche Trends für eine "Vor-Ort-Elektronik" gibt es auch in anderen Bereichen der Kraftfahrzeuge, beispielsweise bei Motorsteuerungen und Bremssystemen. Aufgrund des geringen Bauraums eignen sich dazu besonders gut flexible Leiterträger zur Verteilung von elektrischen Signalen und Strömen. Derartige Leiterträger bestehen regelmäßig aus zwei Polyimidfolien, zwischen denen leitende Kupferbahnen eingebettet sind.

Falls derartige Leiterträger beispielsweise im Getriebegehäuse eingebaut sind, so müssen nicht isolierte Kontaktstellen der Leiterträger gegenüber Partikeln im umgebenden Medium, beispielsweise Öl, abgedichtet werden. Ein Eindringen eines der Partikel in den Bereich der nicht isolierten Kontaktstelle des Leiterträgers kann zu einem Kurzschluss und somit zu einer Störung und/oder Beschädigung der Steuerelektronik führen, die den Leiterträger umfasst.

Aus der DE 199 29 179 A1 ist ein Leiterträger bekannt. Dieser weist eine Kontakt-Isolierfolie mit zwei Ausnehmungen auf und eine Leiterbahn, die zwischen den beiden Isolierfolien eingebettet ist und die mit den beiden Ausnehmungen einen Überlappungsbereich bildet.

Es ist Aufgabe der Erfindung, einen Leiterträger und eine Anordnung mit dem Leiterträger zu schaffen, die einfach eine weitgehend partikeldichte Kontaktierung des Leiterträgers ermöglichen.

Die Aufgabe wird gelöst durch die Merkmale der unabhängigen Ansprüche. Vorteilhafte Ausgestaltungen der Erfindung sind in den Unteransprüchen angegeben.

Die Erfindung zeichnet sich bezüglich eines ersten Aspekts der Erfindung durch einen Leiterträger aus. Der Leiterträger umfasst eine Basis-Isolierfolie, eine Kontakt-Isolierfolie, zumindest eine erste und zweite Leiterbahn und einen Isolierbereich. Die Kontakt-Isolierfolie weist zumindest eine erste und eine zweite Ausnehmung auf. Die erste und die zweite Leiterbahn sind zwischen den beiden Isolierfolien eingebettet. Die erste und die zweite Leiterbahn bilden jeweils mit der ersten bzw. der zweiten Ausnehmung der Kontakt-Isolierfolie einen ersten Überlappungsbereich. Der Isolierbereich trennt die erste Leiterbahn von der zweiten Leiterbahn isolierend ab. Im Isolierbereich ist die Kontakt-Isolierfolie weniger erhaben als außerhalb des Isolierbereichs. Der Isolierbereich erstreckt sich zumindest zwischen der ersten und der zweiten Ausnehmung der Kontakt-Isolierfolie mäanderförmig.

Falls der Leiterträger im Bereich der Ausnehmungen der Kontakt-Isolierfolie gegenüber der Umgebung abgedichtet wird, so trägt der mäanderförmige Verlauf des Isolierbereichs einfach zu einem verminderten Eindringen von Partikeln in den abgedichteten Bereich bei.

Die Erfindung zeichnet sich gemäß eines zweiten Aspekts der Erfindung durch eine Anordnung mit einer Kontaktplatte, einer Basisplatte und dem Leiterträger aus. Die Kontaktplatte weist zumindest einen ersten und einen zweiten elektrischen Kontakt auf. Der Leiterträger ist so zwischen der Kontaktplatte und der Basisplatte angeordnet, dass die erste und die zweite Leiterbahn im ersten Überlappungsbereich mit dem ersten bzw. dem zweiten elektrischen Kontakt elektrisch gekoppelt ist. Ferner weist die Anordnung einen Druckkörper auf, der zwischen der Basisplatte und der Basis-Isolierfolie so angeordnet und ausgebildet ist, dass die Kontakt-Isolierfolie durch den Druckkörper in einem Druckbereich gegen die Kontaktplatte gedrückt wird. Der Druckbereich umschließt jeweils die erste und die zweite Ausnehmung der Kontakt-Isolierfolie. Der Druckbereich bildet einen zweiten Überlappungsbereich mit dem Isolierbereich.

Der Druckkörper bewirkt ein gutes Abdichten der Ausnehmungen und insbesondere der elektrischen Kontakte der Leiterbahnen gegenüber der Umgebung außerhalb des Druckbereichs. Im Isolierbereich erschwert die mäanderförmige Erstreckung des Isolierbereichs das Eindringen von Partikeln in den Druckbereich. Dies trägt einfach und wirkungsvoll zu einer weitgehend partikeldichten Kontaktierung des Leiterträgers an den elektrischen Kontakten bei. In einer weiteren vorteilhaften Ausgestaltung der Anordnung weist die Basisplatte im Bereich des Druckkörpers eine Ausnehmung auf. Der Druckkörper ist in der Ausnehmung der Basisplatte angeordnet und ragt aus ihr hervor. Dies trägt einfach zu einer präzisen Fixierung und/oder Positionierung des Druckkörpers bei.

In einer weiteren vorteilhaften Ausgestaltung der Anordnung umfasst der Druckkörper zwei zylinderförmige Teilkörper. Die Ränder der zylinderförmigen Teilkörper drücken auf den Leiterträger und geben so den Druckbereich vor. Die Ränder der zylinderförmigen Teilkörper tragen zu einer einfachen Ausgestaltung des Druckbereichs bei.

In einer weiteren vorteilhaften Ausgestaltung der Anordnung umfasst der Druckkörper einen ersten und einen zweiten becherförmigen Teilkörper, deren Seitenwände die zylinderförmigen Teilkörper umfassen. Becherböden der becherförmigen Teilkörper tragen einfach zur Stabilität des Druckkörpers bei.

In einer weiteren vorteilhaften Ausgestaltung der Anordnung ist der Druckkörper einstückig ausgebildet. Dies trägt zu einer einfachen Montage des Druckkörpers bei.

Die Erfindung ist im Folgenden anhand von schematischen Zeichnungen näher erläutert.

Es zeigen:
- Figur 1: eine erste Explosionsdarstellung einer Anordnung mit einer ersten Ausführungsform eines Leiterträgers,
- Figur 2: eine zweite Explosionsdarstellung der Anordnung mit der ersten Ausführungsform des Leiterträgers,
- Figur 3: einen Schnitt durch den Leiterträger gemäß Figur 1,
- Figur 4: eine zweite Ausführungsform des Leiterträgers.

Elemente gleicher Konstruktion oder Funktion sind figurenübergreifend mit den gleichen Bezugszeichen gekennzeichnet.

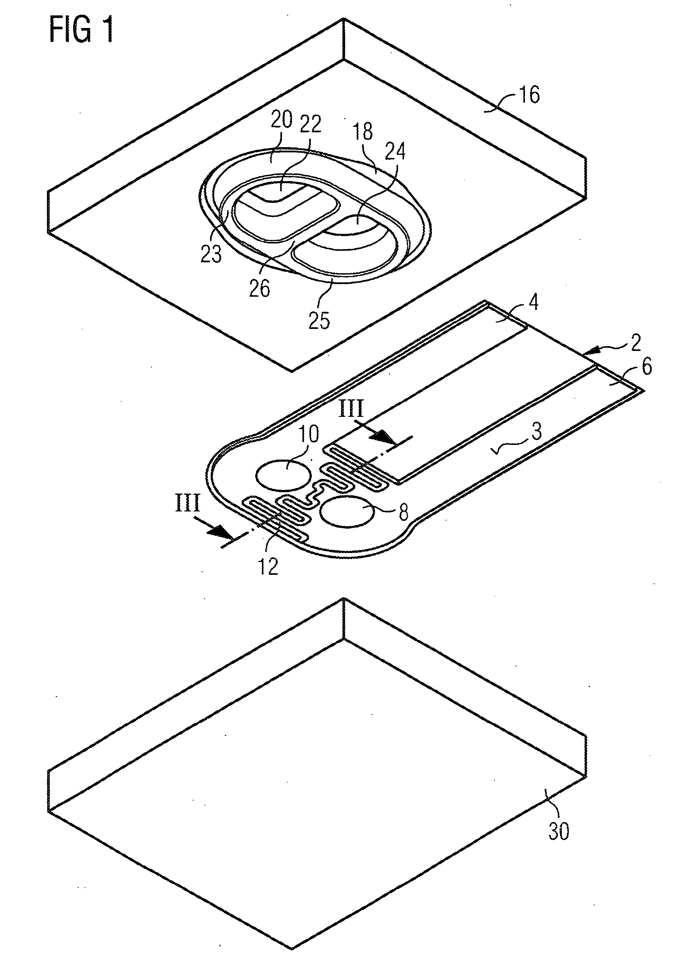

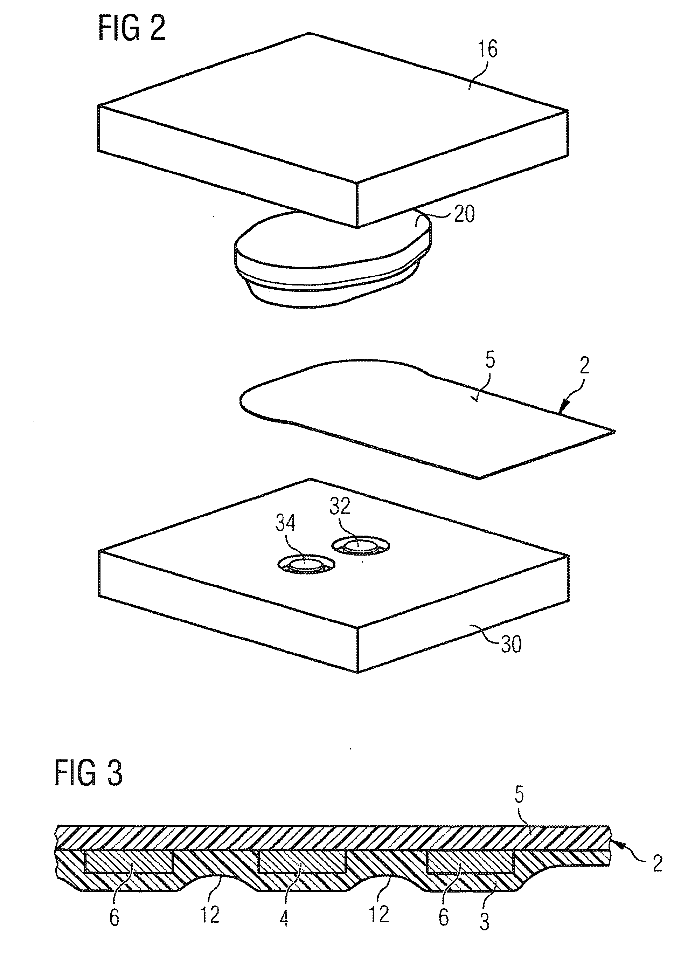

Eine Anordnung (Figur 1) umfasst einen Leiterträger 2. Der Leiterträger 2 weist eine erste Leiterbahn 4 und eine zweite Leiterbahn 6 auf. Die Leiterbahnen umfassen vorzugsweise Kupfer. Die Leiterbahnen sind zwischen einer Kontakt-Isolierfolie 3 und einer Basis-Isolierfolie 5 (Figur 2) angeordnet. Ein Isolierbereich 12, in dem keine Leiterbahn zwischen den beiden Isolierfolien eingebettet ist, trennt die erste Leiterbahn 4 isolierend von der zweiten Leiterbahn 6 ab.

Die Kontakt-Isolierfolie weist eine erste und eine zweite Ausnehmung 8,10 auf. Die Ausnehmungen bilden jeweils einen ersten Überlappungsbereich mit den Leiterbahnen. Somit können die Leiterbahnen im Bereich der Ausnehmungen der Kontakt-Isolierfolie kontaktiert werden. Der Isolierbereich 12 weist zumindest zwischen den Ausnehmungen der Kontakt-Isolierfolie 3 einen mäanderförmigen Verlauf auf.

Ferner umfasst die Anordnung eine Basisplatte 16. Die Basisplatte 16 weist vorzugsweise eine Ausnehmung 18 auf. In der Ausnehmung 18 ist ein Druckkörper 20 angeordnet. Der Druckkörper 20 kann beispielsweise zwei zylinderförmige Teilkörper aufweisen. Vorzugsweise weist jedoch der Druckkörper 20 einen ersten und einen zweiten becherförmigen Teilkörper 22, 24 auf. Ferner weist der Druckkörper vorzugsweise einen Rand 23 des ersten becherförmigen Teilkörpers 22 und einen Rand 25 des zweiten becherförmigen Teilkörpers 24 auf. Bevorzugt bilden der Rand 23 des ersten becherförmigen Teilkörpers 22 und der Rand 25 des zweiten becherförmigen Teilkörpers 24 zusammen einen Trennsteg 26. Bei einer alternativen Ausführungsform kann der Druckkörper 20 auch anders ausgestaltet sein. Wichtig ist jedoch, dass der Druckkörper 20 dazu beiträgt, die Ausnehmungen der Kontakt-Isolierfolie 3 und die Kontakte der Kontaktplatte 30 gegeneinander und gegenüber der Umgebung abzudichten. Der Druckkörper 20 umfasst vorzugsweise ein elastisches Material, beispielsweise Hartgummi.

Ferner umfasst die Anordnung vorzugsweise eine Kontaktplatte 30. Die Kontaktplatte 30 weist zumindest zwei Ausnehmungen auf, in denen ein erster elektrischer Kontakt 32 und ein zweiter elektrischer Kontakt 34 angeordnet sind. Von den elektrischen Kontakten können elektrische Leitungen abzweigen.

Die Kontakt-Isolierfolie 3, die Basis-Isolierfolie 5 und die Leiterbahnen des Leiterträgers 2 sind vorzugsweise so ausgebildet, dass der Leiterträger 2 sehr flexibel ist.

Zum Kontaktieren des Leiterträgers 2 an den elektrischen Kontakten der Kontaktplatte 30 wird der Leiterträger 2 so auf der Kontaktplatte 30 angeordnet, dass die zweite Leiterbahn 6 im Bereich der ersten Ausnehmung 8 der Kontaktfolie 3 direkt mit dem ersten elektrischen Kontakt 32 der Kontaktplatte 30 gekoppelt ist und dass die erste Leiterbahn 4 im Bereich der zweiten Ausnehmung 10 der Kontaktfolie 3 mit dem zweiten elektrischen Kontakt 34 der Kontaktplatte 30 direkt gekoppelt ist. Die zweite Leiterbahn 6 kann beispielsweise mit einem Laser mit dem ersten elektrischen Kontakt 32 bzw. die erste Leiterbahn 4 mit dem zweiten elektrischen Kontakt 34 verschweißt werden.

Nachfolgend wird die Basisplatte 16 mit dem Druckkörper 20 so gegen den Leiterträger 2 und die Kontaktplatte 30 gedrückt und fixiert, dass der Trennsteg 26 des Druckkörpers 20 einen zweiten Überlappungsbereich mit dem mäanderförmigen Isolierbereich 12 bildet. Ferner wird der Leiterträger 2 so gegen die Basisplatte 30 gedrückt, dass sich ein Druckbereich bildet, in dem die Kontaktfolie 3 direkt mit der Oberfläche der Kontaktplatte 30 gekoppelt ist. Der Druckbereich ist so ausgebildet, dass er die Ausnehmungen der Kontaktfolie 3 voneinander und gegenüber der Umgebung abtrennt. So können, falls die Anordnung in einem Medium angeordnet ist, beispielsweise in Öl, keine Partikel, die sich im Medium befinden, in den Druckbereich eindringen und dort einen Kurzschluss an den elektrischen Kontakten verursachen.

Aufgrund der fehlenden Leiterbahnen im Isolierbereich 12 (Figur 3) ist der Isolierbereich gegenüber dem Bereich, in dem sich die Leiterbahnen befinden, weniger erhaben. Somit ergeben sich im zweiten Überlappungsbereich zwischen dem Isolierbereich 12 und dem Trennsteg 26 regelmäßig kleine Zwischenräume, durch die Partikel in den Druckbereich eindringen können. Der mäanderförmige Verlauf des Isolierbereichs 12 erschwert jedoch das Eindringen der Partikel, da diese vorzugsweise mehrere Windungen der Mäanderform überwinden müssen, um in den Druckbereich zu gelangen.

Ein Maß dafür, wie leicht bzw. wie schwer die Partikel eindringen können, kann durch die Dimensionierung der Ränder der becherförmigen Teilkörper des Druckkörpers 20 im Verhältnis zur Dimensionierung des mäanderförmigen Isolierbereichs 12 vorgegeben werden. Sind beispielsweise die Ränder halb so breit wie die Breite der Fläche, über die sich der mäanderförmige Isolierbereich 12 erstreckt, so können die Partikel nahezu gradlinig zwischen dem Isolierbereich 12 und dem Druckkörper 20 durchgelangen. Sind im Gegensatz dazu die Ränder breiter als die Breite der Fläche, über die sich der mäanderförmige Isolierbereich 12 erstreckt, und/oder der mäanderförmige Isolierbereich 12 sehr fein und/oder sehr verschlungen, so müssen die Partikel mehrere Windungen überwinden, um in den Druckbereich einzudringen, was die Wahrscheinlichkeit des Eindringens stark verringert. Somit sind die Ränder vorzugsweise so dimensioniert, dass ein Partikel aus dem Medium zumindest eine Windung des mäanderförmigen Isolierbereichs überwinden muss, um in den vom Druckbereich umschlossenen Bereich eindringen zu können.

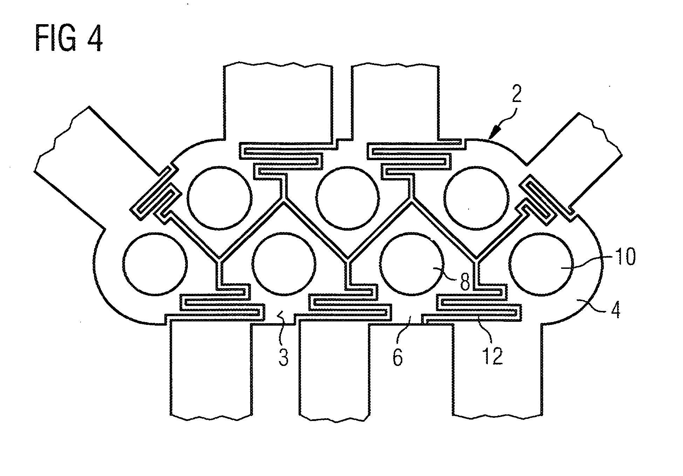

Bei einer alternativen Ausführungsform kann der Leiterträger 2 beliebig viele Leiterbahnen umfassen. Beispielsweise umfasst der Leiterträger 2 sieben Leiterbahnen (Figur 4). Für jede weitere Leiterbahn ist dann zumindest ein weiterer mäanderförmiger Isolierbereich 12 vorgesehen. Ferner weist der Leiterträger 2 für jede weitere Leiterbahn eine weitere Ausnehmung in der Kontakt-Isolierfolie 3 auf. Ferner weist die Kontaktplatte 30 für jede weitere Leiterbahn einen weiteren elektrischen Kontakt auf. Auch der Druckkörper 20 ist dann so ausgebildet, dass die weiteren Ausnehmungen der Kontakt-Isolierfolie 3 und die weiteren elektrischen Kontakte der Kontaktplatte 30 gegeneinander und gegenüber der Umgebung partikeldicht abgedichtet sind.

Die Erfindung ist nicht auf die angegebenen Ausführungsbeispiele beschränkt. Beispielsweise kann der Druckkörper 20 mehrstückig ausgebildet sein. Der erste und der zweite becherförmige Teilkörper 22, 24 des Druckkörpers können lediglich zylinderförmig ausgebildet sein. Die Leiterbahnen.können alternativ oder zusätzlich andere Materialien als Kupfer umfassen. Ferner kann der Leiterträger 2 mehrere Schichten, in denen sich Isolierfolien und Leiterbahnen abwechseln, aufweisen.

## Patentansprüche

1. Leiterträger (2) umfassend
- eine Basis-Isolierfolie (5),
- eine Kontakt-Isolierfolie (3), die zumindest eine erste und eine zweite Ausnehmung (8, 10) aufweist,
- zumindest eine erste und eine zweite Leiterbahn (4, 6), die zwischen den beiden Isolierfolien eingebettet sind und die jeweils mit der ersten beziehungsweise zweiten Ausnehmung (8, 10) der Kontakt-Isolierfolie (3) einen ersten Überlappungsbereich bilden,
- einen Isolierbereich (12), der die erste Leiterbahn (4) von der zweiten Leiterbahn (6) isolierend abtrennt, in dem die Kontakt-Isolierfolie (3) weniger erhaben ist als außerhalb des Isolierbereichs (12) und der sich zumindest zwischen der ersten und der zweiten Ausnehmung (8, 10) der Kontakt-Isolierfolie (3) mäanderförmig erstreckt.

2. Anordnung mit
- einer Kontaktplatte (30), die zumindest einen ersten und einen zweiten elektrischen Kontakt (32, 34) aufweist,
- einer Basisplatte (16),
- der Leiterträger (2) gemäß Anspruch 1, die so zwischen der Kontaktplatte (30) und der Basisplatte (16) angeordnet ist, dass die erste und die zweite Leiterbahn (4, 6) in den Überlappungsbereichen mit dem ersten bzw. dem zweiten elektrischen Kontakt (32, 34) elektrisch gekoppelt ist,
- einem Druckkörper (20), der zwischen der Basisplatte (16) und der Basis-Isolierfolie (5) so angeordnet und so ausgebildet ist, dass die Kontakt-Isolierfolie (3) durch den Druckkörper (20) in einem Druckbereich gegen die Kontaktplatte (30) gedrückt wird, der jeweils die erste und die zweite Ausnehmung (8,10) der Kontakt-Isolierfolie (3) umschließt und der einen zweiten Überlappungsbereich mit dem Isolierbereich (12) bildet.

3. Anordnung gemäß Anspruch 2, bei der die Basisplatte (16) im Bereich des Druckkörpers (20) eine Ausnehmung (18) aufweist, in der der Druckkörper (20) angeordnet ist und aus der der Druckkörper (20) hervorragt.

4. Anordnung gemäß einem der Ansprüche 2 oder 3, bei der der Druckkörper (20) zwei zylinderförmige Teilkörper umfasst, deren Ränder auf den Leiterträger (2) drücken und so den Druckbereich vorgeben.

5. Anordnung gemäß Anspruch 4, bei der der Druckkörper (20) einen ersten und einen zweiten becherförmigen Teilkörper (22, 24) umfasst, deren Seitenwände die zylinderförmigen Teilkörper umfassen.

6. Anordnung gemäß einem der Ansprüche 2 bis 5, bei der der Druckkörper (20) einstückig ausgebildet ist.

## Claims

1. Conductor carrier (2) that includes
- a base-insulating film (5),
- a contact-insulating film (3) having at least one first and one second recess (8, 10),
- at least one first and one second printed conductor (4, 6) that are embedded between the two insulating films and which in each case with respectively the first and second recess (8, 10) of the contact-insulating film (3) form a first overlapping region, and
- an insulating region (12), which separates the first printed conductor (4) from the second printed conductor (6) in an insulating manner, inside which the contact-insulating film (3) is less raised than outside the insulating region (12) and which extends at least between the first and second recess (8, 10) of the contact-insulating film (3) in a meandering fashion.

2. Arrangement having
- a contact plate (30) that has at least one first and one second electric contact (32, 34),
- a base plate (16),
- the conductor carrier (2) according to claim 1 that is arranged between the contact plate (30) and base plate (16) in such a way that the first and second printed conductor (4, 6) are electrically coupled within the overlapping regions to the first and second electric contact (32, 34) respectively,
- a pressure body (20) that is arranged between the base plate (16) and base-insulating film (5) and embodied in such a way that the contact-insulating film (3) will be pressed by the pressure body (20) against the contact plate (30) in a pressure region that in each case includes the first and second recess (8,10) of the contact-insulating film (3) and forms a second overlapping region with the insulating region (12).

3. Arrangement according to claim 2 wherein the base plate (16) has in the region of the pressure body (20) a recess (18) in which the pressure body (20) is located and from which the pressure body (20) projects.

4. Arrangement according to one of claims 2 or 3 wherein the pressure body (20) encompasses two cylindrical partial bodies whose edges press onto the conductor carrier (2), thereby defining the pressure region.

5. Arrangement according to claim 4 wherein the pressure body (20) includes a first and second pot-shaped partial body (22, 24) whose side walls encompass the cylindrical partial bodies.

6. Arrangement according to one of claims 2 to 5 wherein the pressure body (20) is embodied as a single piece.

## Revendications

1. Support conducteur (2), comprenant :
- une feuille isolante de base (5),
- une feuille isolante de contact (3), qui présente au moins un premier évidement et un second évidement (8, 10),
- au moins une première et une seconde piste conductrice (4, 6), qui sont insérées entre les deux feuilles isolantes et qui forment respectivement une première zone de chevauchement avec le premier évidement ou le second évidement (8, 10) de la feuille isolante de contact (3),
- une zone isolante (12), qui sépare de manière isolante la première piste conductrice (4) de la seconde piste conductrice (6), dans laquelle la feuille isolante de contact (3) est moins saillante qu'en dehors de la zone isolante (12) et qui s'étend en méandres au moins entre le premier évidement et le second évidement (8, 10) de la feuille isolante de contact (3).

2. Agencement, comprenant :
- une plaque de contact (30), qui présente au moins un premier et un second contacts électrique (32, 34),
- une plaque de base (16),
- le support conducteur (2) selon la revendication 1, qui est agencé entre la plaque de contact (30) et la plaque de base (16) de manière à coupler électriquement les première et seconde pistes conductrices (4, 6) dans les zones de chevauchement respectivement avec les premier et second contacts électriques (32, 34),
- un corps de pression (20), qui est agencé et formé entre la plaque de base (16) et la feuille isolante de base (5) de sorte que la feuille isolante de contact (3) soit pressée par le corps de pression (20) dans une zone de pression contre la plaque de contact (30), qui entoure respectivement les premier et second évidements (8,10) de la feuille isolante de contact (3) et qui forme une seconde zone de chevauchement avec la zone isolante (12).

3. Agencement selon la revendication 2, dans lequel la plaque de base (16) présente, dans la zone du corps de pression (20), un évidement (18) dans lequel est agencé le corps de pression (20) et duquel dépasse le corps de pression (20).

4. Agencement selon l'une quelconque des revendications 2 ou 3, dans lequel le corps de pression (20) comprend deux corps partiels cylindriques, dont les bords appuient sur le support conducteur (2) et imposent de la sorte la zone de pression.

5. Agencement selon la revendication 4, dans lequel le corps de pression (20) comprend un premier et un second corps partiel (22, 24) en forme de cuvette, dont les parois latérales comprennent les corps partiels cylindriques.

6. Agencement selon l'une quelconque des revendications 2 à 5, dans lequel le corps de pression (20) est formé d'un seul tenant.
